# EUROPEAN PATENT APPLICATION

(11) **EP 1 465 250 A1**
(43) Date of publication of application: **06.10.2004**
(21) Application number: 03405223.3
(22) Date of filing: 02.04.2003
(51) Int. Cl.: H01L 23/24, H01L 23/373, H01L 23/498

(54) **Insulated power semiconductor module with reduced partial discharge and manufacturing method**

(71) Applicant: ABB RESEARCH LTD., 8050 Zürich (CH)
(72) Inventor: Hamidi, Amina, 5400 Baden (CH); Knapp, Wolfgang, 5600 Lenzburg (CH); Meysenc, Luc, 5405 Baden-Dättwil (CH); Keser, Helmut, 5443 Niederrohrdorf (CH)
(74) Representative: ABB Patent Attorneys

(57) **Abstract**

A method for assembling a power semiconductor module with reduced partial discharge behavior is described. The method comprises the steps of bonding an insulating substrate (2) onto a bottom plate (11); disposing a first conductive layer (4) on a portion of said insulating substrate (2), so that at least one peripheral top region of said insulating substrate (2) remains uncovered by the first conductive layer (4); bonding a semiconductor chip (6) onto said first conductive layer (4); disposing a precursor (51) of a first insulating material (5) in a first corner (24) formed by said first conductive layer (4) and said peripheral region of said insulating substrate (2); polymerizing the precursor (51) of the first insulating material (5) to form the first insulating material (5); and covering said semiconductor chip (6), said substrate (2), said first conductive layer (4), and said first insulating material (5) at least partially with a second insulating material. According to the invention, the precursor (51) of the first insulating material is a low viscosity monomer or oligomer, which forms a polyimide when polymerizing. Also disclosed is a semiconductor module with reduced partial discharge behavior.

## Description

### Technical Field

The invention described herein relates to the field of semiconductor devices. It relates in particular to a manufacturing method for a power semiconductor module with reduced partial discharge behavior and a power semiconductor module with reduced partial discharge behavior as described in the preamble of the independent claims.

### Background of the invention

Electrical discharges that do not completely bridge electrodes of electric devices or modules are called partial discharges. High voltage (HV) components and equipment, as for example HV capacitors, HV cables, HV transformers, HV insulated power modules, in particular power semiconductor modules, etc., are particularly prone to failure due to partial discharges. Although a magnitude of such discharges is usually small, they cause progressive deterioration and may lead to ultimate failure of semiconductor devices or modules.

Components that are notoriously affected by partial discharges in insulated HV modules that are filled with silicone gel are metallized ceramic substrates that are embedded in the silicone gel. One reason for this is an enhancement of an electric field at sharp structures at edges of the metallization.

In addition, the silicone gel that is used in order to ensure electrical insulation inside the module, is not an absolute barrier against moisture and its adhesion to the ceramic substrates is often not perfect. A resulting delamination of the gel and/or a presence of bubbles resulting from a moisture uptake and subsequent evaporation due to heating during an operation of the modules can cause severe partial discharge activity.

These problems can be partially overcome by introducing an electrically insulating polyester or epoxy resin that covers the borders of the metallization disposed on the ceramic substrate, as described in US patent US 6,201,696 B1. However, due to a surface roughness of the ceramic substrate and the metallization, small, air filled cavities will remain under the metallization in a neighborhood of the metallization border. This problem is described in PCT application WO 01/87500 A2. To overcome the problem, WO 01/87500 A2 suggests to subject a coating fluid disposed on the ceramic substrate and/or the metallization edge to an increased pressure in order to force the coating fluid into the cavities.

In addition, a layout of the metallization on the ceramic substrate is in general obtained by an etching process, which usually results in borders with many metal inhomogeneities which in turn lead to local high field densities during an operation of the module. When applying the silicone gel coating, the adhesion is not good at such critical locations and air bubbles are often present leading to PD activity.

### Description of the invention

It is an object of the invention to provide a method for manufacturing a power semiconductor module of the kind mentioned initially in which an occurrence of partial discharges is effectively reduced. It is also an objective of the invention to provide a corresponding power semiconductor module.

These objects are achieved by a method for manufacturing a power semiconductor module according to claim 1 and a power semiconductor module according to claim 7.

According to the invention, in a method for producing a power semiconductor module according to claim 1, a low viscosity monomer or oligomer is disposed in a first corner formed by a first conductive layer and a peripheral region of an electrically insulating substrate. The viscosity has to be chosen low enough for the monomer or oligomer to be capable of creeping into any cavities that may exist between the electrically insulating substrate and the first conductive layer in a neighborhood of edges of the first conductive layer. Preferably, a viscosity *v* with *v* ≤ 1.0 Pa·s, preferably *v* < 0.5 Pa·s, is chosen. The monomer or oligomer will subsequently polymerize and form a polymer, which may occur automatically with time or may be induced by physical or chemical treatment of the monomer or oligomer. No gas filled cavities will thus remain between the electrically insulating substrate, the first conductive layer disposed thereon and the polymer. In addition, a first insulating material resulting from polymerization of the monomer or oligomer will act as a humidity barrier at the borders of the conductive layer. As a consequence, the resulting modules exhibit reduced partial discharge, without the necessity of additional process steps like subjection to elevated pressures, etc.

According to the invention, in a semiconductor module according to claim 7, a polyimide is provided as a first insulating material in a corner formed by a peripheral region of an electrically insulating substrate and an electrically conductive layer disposed on said substrate. Polyimide is preferably formed by polymerization of a corresponding monomer or oligomer, thus allowing the power semiconductor module to be manufactured in a cost-efficient manner.

### Brief Explanation of the Figures

The invention will be explained in more detail in the following text with reference to exemplary realizations and in conjunction with the figures, in which:
Figs. 1a-e show an example of a method to manufacture a power semiconductor module according to the invention,
Figs. 2a-f show an alternative embodiment of the method to manufacture a power semiconductor module according to the invention,
Fig. 3 shows a bottom part of a power semiconductor module according to the invention,
Fig. 4 shows a bottom part of a preferred embodiment of the power module according to the invention,
Fig. 5 shows a bottom part of another preferred embodiment of the power module according to the invention.

Fig. 6 shows another preferred embodiment of the power module according to the invention.

The reference signs used in the figures are explained in the list of reference signs.

### Detailed description of preferred embodiments

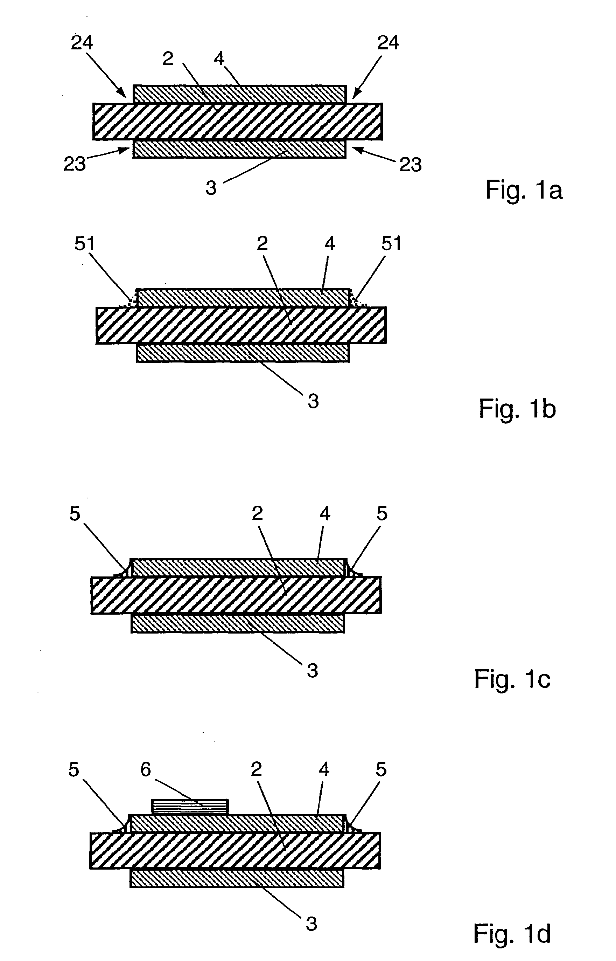

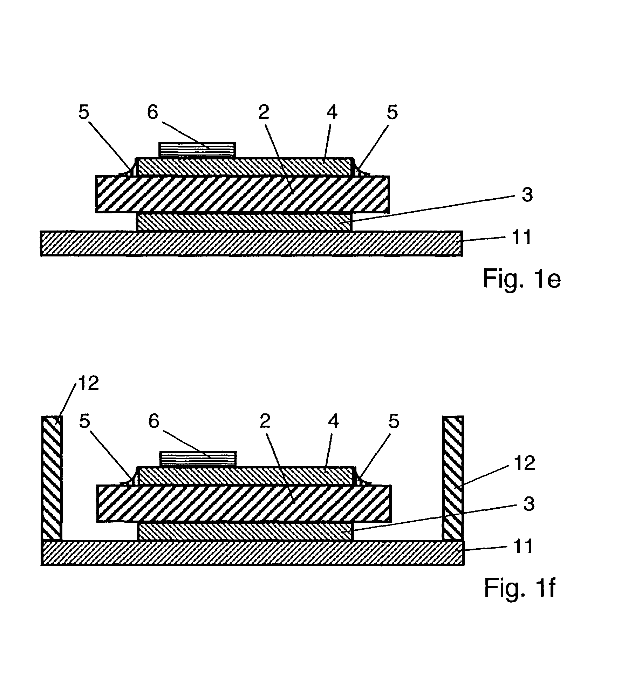

Figs. 1a-e show an example of a method to manufacture a power semiconductor module according to the invention. Starting point is an electrically insulating ceramic substrate 2 as shown in Fig. 1a on which a top metallization layer 4 and a bottom metallization layer 3 have been disposed. The top metallization layer 4 covers only a portion of a top surface of the ceramic substrate 2, so that first corners 24 are formed by the top metallization layer 4 and the ceramic substrate 2. Similarly, the bottom metallization layer 4 covers only a portion of a bottom surface of the ceramic substrate 2, so that second corners 23 are formed. A low viscosity polyimide precursor 51 is then applied in the corners 24 as shown in Fig. 1b. Preferably, the polyimide precursor 51 comprises a polyamic acid in a solvent, e.g. N-methyl-2-pyrrolidone, to give a viscosity *v* with *v* ≤ 1.0 Pa·s. Application is preferably done by drop dispensing. Preferably, the polyimide precursor 51 has a high capilarity and comprises built-in adhesion promoters, preferably siloxane based, for improved adhesion capability to both metals and ceramic. The polyimide precursor 51 is then cured by being subjected to elevated temperatures, typically 200-350°C, for several ten minutes, preferably for approximately one hour. As a result of the curing polyimide precursor 51 will form a polyimide 5 through polymerization of monomers and/or oligomers contained in the polyimide precursor 51, as shown in Fig. 1c. In a subsequent step, a semiconductor chip 6 is soldered onto the top metallization layer 4. A resulting configuration as shown in Fig. 1d will be referred to as a chip carrier in what follows. In a next step as shown in Fig. 1e, the chip carrier is bonded onto a bottom plate 11. This is preferably done by low temperature soldering, but high temperature soldering may also be used. Preferably, after the semiconductor chip 6 has been mounted, power terminals and/or connecting wires are attached to the semiconductor and/or the top metallization layer 4 in a manner known to a person skilled in the art, e.g. by wire bonding. Housing side walls 12 are then glued onto the bottom plate 11. A resulting bottom part of a module housing is then filled with silicone gel 8, so that the top metallization layer 4, the semiconductor chip 6, the ceramic substrate 2, and the polyimide 5 are covered by the silicone gel 8. Preferably, the silicone gel 8 is subsequently hardened at elevated temperatures.

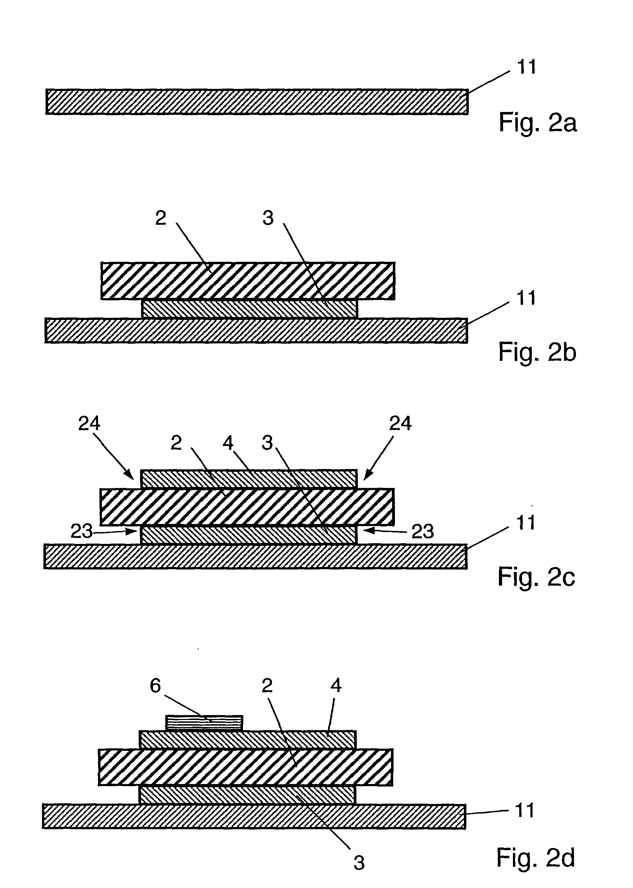

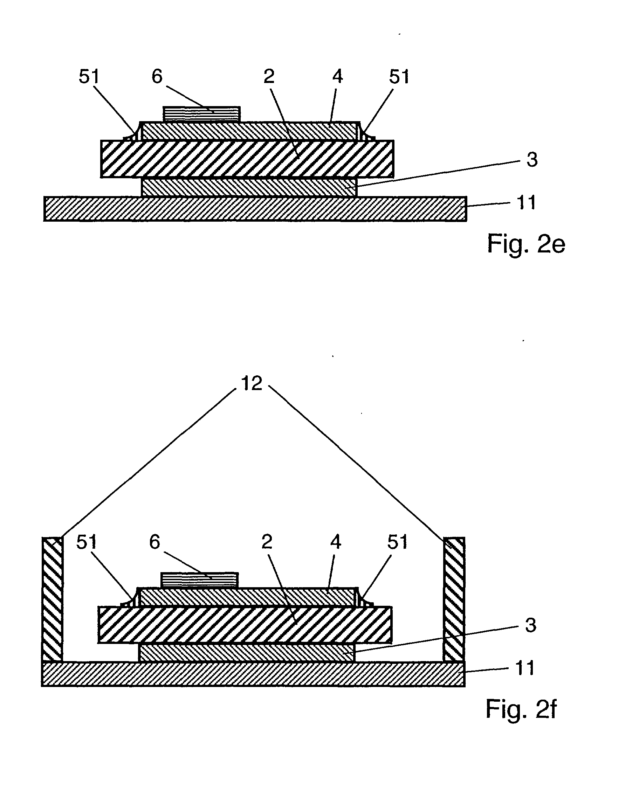

As will be understood by a person skilled in the art, process steps may be interchanged in the method according to the invention. Figs. 2a-f show an alternative embodiment of the method according to the invention. In this case, the electrically insulating ceramic substrate 2 is bonded onto the bottom plate 11 in a first step, the bond being established by the bottom metallization layer 3 that is disposed between the ceramic substrate 2 and the bottom plate 11. In a next process step as shown in Fig 2c, the top metallization layer 4 is formed on a portion of the top surface of the ceramic substrate 2. In a subsequent step as shown in Fig. 2d, the semiconductor chip 6 is bonded onto the top metallization layer 4. The polyimide precursor 51 is then disposed in the corners 24 formed by the top metallization layer 4 and the ceramic substrate 2 as shown in Fig. 2e. The bottom part of the module housing is then formed by attaching the housing side walls 12 to the bottom plate 11 as shown in Fig. 2f. After that, the chip carrier, which in turn comprises the top metallization layer 4, the semiconductor chip 6, the ceramic substrate 2, and the polyimide 5, is covered with silicone gel 8 filled into the bottom part of the module housing.

In a preferred variation of the method according to the invention, a primer is disposed on at least a part of the top metallization layer 4, the semiconductor chip 6 and the ceramic substrate 2 before the silicone gel 8 is filled into the bottom part of the housing. Preferably, the primer used is a liquid having a low viscosity, and preferably contains reactive silicone resins in a solvent. After application of the primer, and after the solvent has evaporated, a rigid film of resin 7 is formed on exposure to atmospheric moisture at room temperature or elevated temperatures. This rigid film of resin 7 performs two functions: to adhere both to the chip carrier and to the silicone gel 8. Preferably, the primer is applied just before the silicone gel 8 is filled into the bottom part of the housing, but may advantageously also be applied by dipping the chip carrier into the primer, preferably after it has been mounted onto the bottom plate 11.

In another preferred variation of the method, at least one peripheral bottom region of the ceramic substrate 2 remains uncovered by the bottom metallization layer 3. The polyimide precursor is subsequently disposed in a second corner 23 formed by the bottom metallization layer 3 and the peripheral bottom region of the ceramic substrate 2.

In another preferred variation of the method, the chip carrier is not mounted onto a bottom plate 11. In this variation, the chip carrier is held in place relative to a top part of a housing by fixing means, preferably a sticky tape or foil, an the silicone gel 8 is attached to the chip carrier through a hole in the top part of the housing. After curing of the silicone gel 8, the sticky tape or foil is removed. This permits the module to be mounted on a cooler without a bottom plate 11 between the ceramic substrate 2 and the cooler, which will result in improved thermal contact.

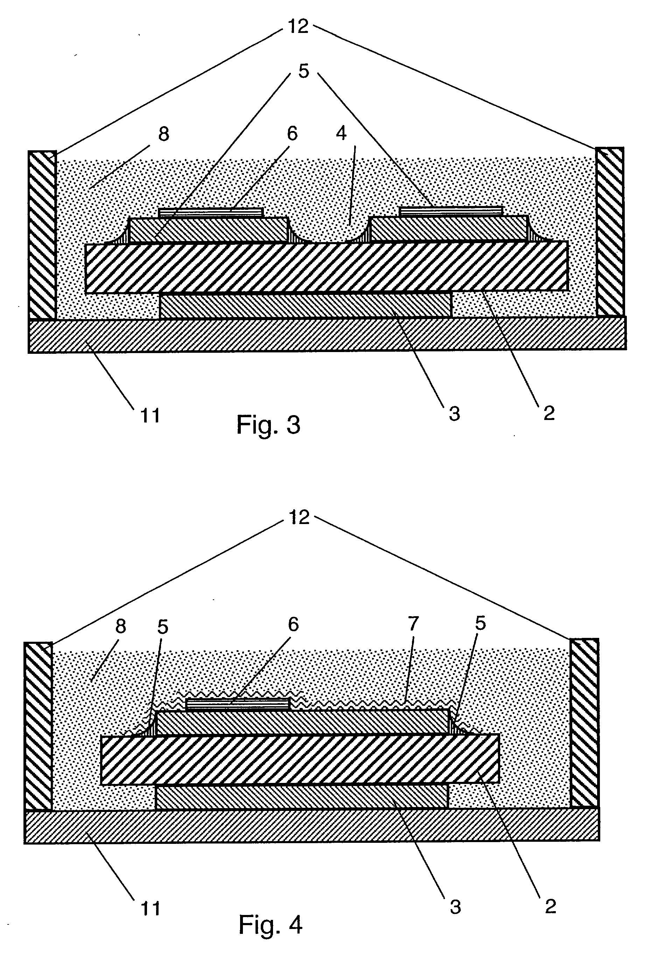

Fig. 3 shows a bottom part of a power semiconductor module according to the invention. An electrically insulating ceramic substrate 2, on which bottom metallization layer 3 and bottom metallization layer 4 have been disposed, is bonded onto a bottom plate 11 which forms a bottom part of the housing together with side walls 12 which consist of an electrically insulating material. Disposed between the bottom metallization layer 3 and the bottom plate 11 is a first solder layer not shown in Fig. 3 which establishes the bond. A semiconductor chip 6 is onto the top metallization layer 4 by a second solder layer not shown in Fig. 3. Polyimide 5 is provided in the corners 24 formed by the top metallization layer 4 and the ceramic substrate 2. The top metallization layer 4, the semiconductor chip 6, the ceramic substrate 2, and the polyimide 5 are covered by silicone gel 8. Preferably, the polyimide has a high relative dielectric constant, i.e. εᵣ > 3.0. Preferably, it also has a high temperature stability, i.e. it will stand temperatures up to at least 300°C and/or a high dielectric strength, i.e. it will withstand electric fields up to 15kV/mm. Preferably it also has a low humidity uptake.

Fig. 4 shows a bottom part of a preferred embodiment of the power module according to the invention. A rigid film of resin 7 that has formed upon exposure of a primer to atmospheric moisture and/or elevated temperatures is disposed between top surfaces of the peripheral region of the ceramic substrate 2, the semiconductor chip 6, the polyimide 5, and the top metallization layer 4 on the one side and the silicone gel 8 on the other side.

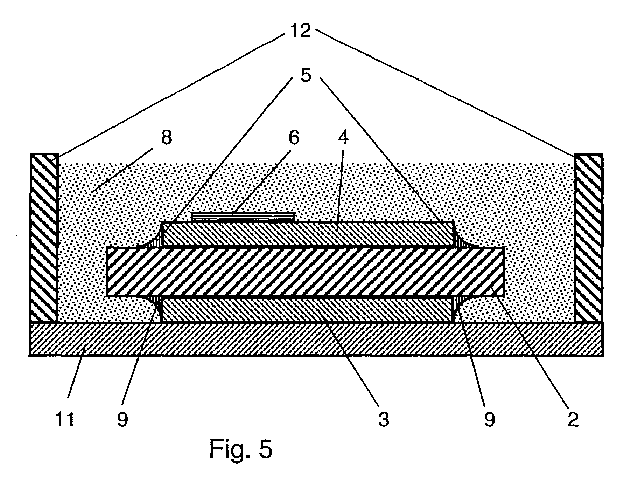

Fig. 5 shows a bottom part of another preferred embodiment of the power module according to the invention. In this embodiment, polyimide 9 is also provided in a second corner 23 formed by the bottom metallization layer 3 and a peripheral region of the bottom surface of the ceramic substrate 2 as a third insulation material. This further reduces partial discharge within the module.

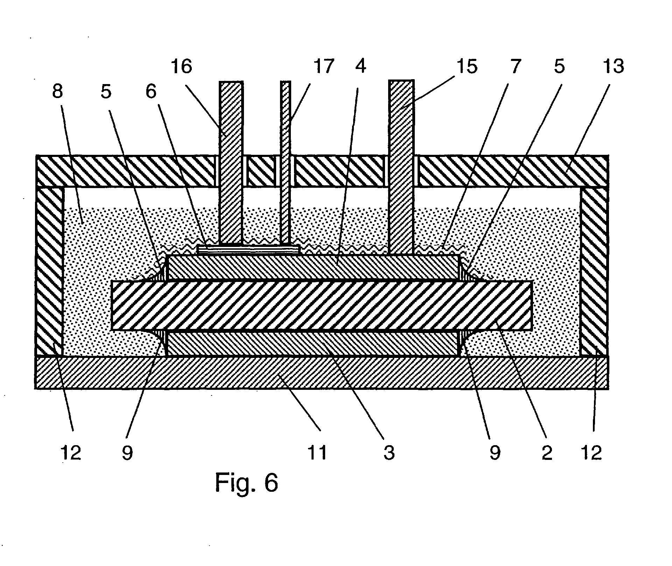

Fig. 6 shows another preferred embodiment of the power module according to the invention. This embodiment comprises both the rigid film of resin 7 and polyimide 9 is disposed in the second corner 23. Also shown in the figure are a top plate 13 of the housing, a first power terminal 15, a second power terminal 16 and a control terminal 17 for an electrical connection of the module. The first and second power terminals 15, 16 contact the top metallization layer 4 and a first main electrode of the semiconductor chip 6, respectively, whereas the control terminal 17 contacts a gate pad of the semiconductor chip 6. All terminals pass through openings in the top plate 13.

### List of reference symbols

- 11: Bottom plate
- 12: Housing side walls
- 13: Top plate
- 15, 16: First, second power terminal
- 17: Control terminal
- 2: Electrically insulating substrate, ceramic substrate
- 24: First corner
- 23: Second corner
- 3: Second electrically conductive layer, bottom metallization layer
- 4: First electrically conductive layer, top metallization layer
- 5: First electrically insulating material, polyimide
- 51: Precursor of first electrically insulating material, polyimide
- 6: Semiconductor chip
- 7: Rigid layer of resin
- 8: Second electrically insulating material, Silicone gel
- 9: Third electrically insulating material, polyimide

## Claims

1. A method for assembling a power semiconductor module, comprising the steps of:
- disposing a first electrically conductive layer (4) on at least one portion of a top surface of an electrically insulating substrate (2), so that at least one peripheral top region of said electrically insulating substrate (2) remains uncovered by the first electrically conductive layer (4);
- disposing a precursor (51) of a first electrically insulating material (5) in a first corner (24) formed by said first electrically conductive layer (4) and said peripheral region of said electrically insulating substrate (2);
- polymerizing the precursor (51) of the first electrically insulating material (5) to form the first electrically insulating material (5);
- bonding a semiconductor chip (6) onto said first electrically conductive layer (4);
- bonding the electrically insulating substrate (2) onto a bottom plate (11);
- covering said semiconductor chip (6), said electrically insulating substrate (2), said first electrically conductive layer (4), and said first electrically insulating material (5) at least partially with a second electrically insulating material (8);
**characterized in that**
- the precursor (51) of the first electrically insulating material (5) is a low viscosity monomer or oligomer.

2. The method as claimed in claim 1, **characterized in that** the electrically insulating substrate (2) is bonded onto a bottom plate (11) before the second electrically insulating material (8) is applied.

3. The method as claimed in claim 1 or 2, **characterized in that** the precursor (51) of the first electrically insulating material (5) is a monomer or oligomer that forms a polyimide when polymerizing.

4. The method as claimed in one of the previous claims, further comprising the steps of
- disposing at least one second electrically conductive layer (3) between the bottom plate (11) and at least one portion of a bottom surface of the electrically insulating substrate (2), so as to selectively expose at least one peripheral bottom region of the electrically insulating substrate (2); and
- disposing a precursor of a third electrically insulating material in a second corner (23) formed by the second electrically conductive layer (3) and the peripheral bottom region of the electrically insulating substrate (2).

5. The method as claimed in one of the previous claims, **characterized in that** the precursor of the third electrically insulating material is identical to the precursor of the first electrically insulating material.

6. The method as claimed in one of the previous claims, **characterized in that** a primer is disposed to at least partially cover the semiconductor chip (6), the electrically insulating substrate (2), the first electrically conductive layer (4), and the first electrically insulating material (5) before the second insulating material is attached.

7. A power semiconductor module, comprising:
- an electrically insulating substrate (2)
- a first electrically conductive layer (4) disposed on at least one portion of a top surface of said electrically insulating substrate (2), so as to selectively expose at least one peripheral top region of said electrically insulating substrate (2);
- at least one semiconductor power chip mounted on said electrically conductive layer (4);
- a first electrically insulating material (5) disposed in a corner formed by said first electrically conductive layer (4) and said peripheral region of said electrically insulating substrate (2);
- a second insulating material (8) at least partially embedding said semiconductor power chip, said electrically insulating substrate (2), said first electrically conductive layer (4), and said first electrically insulating material (5);
**characterized in that**
- the first electrically insulating material (5) is a polyimide.

8. The power semiconductor module as claimed in claim 7, **characterized in that** the electrically insulating substrate (2) is mounted on a bottom plate (11).

9. The power semiconductor module as claimed in claim 7 or 8, **characterized in that** at least one second electrically conductive layer (3) is disposed between the bottom plate (11) and at least one portion of a bottom surface of the electrically insulating substrate (2), so as to selectively expose at least one peripheral bottom region of the electrically insulating substrate (2); and that a third insulating material (9) is disposed in a second corner (23) formed by the second electrically conductive layer (3) and the peripheral bottom region of the electrically insulating substrate (2).

10. The power semiconductor module as claimed in claim 7, 8 or 9, **characterized in that** a rigid layer (7) of resin is provided between the second electrically insulating material (8) and the semiconductor chip (6), the substrate (2), the first conductive layer (4) and the first electrically insulating material (5).
